# EUROPEAN PATENT APPLICATION

(11) **EP 4 502 232 A1**
(43) Date of publication of application: **05.02.2025**
(21) Application number: 23774788.6
(22) Date of filing: 17.03.2023
(51) Int. Cl.: C23F 11/00, C23F 11/12, C11D 7/10, C11D 7/34, C11D 7/36, H01L 21/02, H01L 21/28, H01L 21/304, H01L 21/768, H01L 25/07, H01L 25/065, H01L 25/18

(54) **COMPOSITION FOR PROTECTING COPPER SURFACE, AND METHOD FOR PRODUCING SEMICONDUCTOR INTERMEDIATE AND SEMICONDUCTOR USING SAME**

(30) Priority: 24.03.2022 JP 2022048769
(71) Applicant: MITSUBISHI GAS CHEMICAL COMPANY, INC., Chiyoda-ku Tokyo 100-8324 (JP)
(72) Inventor: OIE, Toshiyuki, Taichung City, 435059 (TW)
(74) Representative: Müller-Boré & Partner Patentanwälte PartG mbB
(86) International application number: PCT/JP2023/010511
(87) International publication number: WO 2023/182193

(57) **Abstract**

A means for preventing oxidation of a copper surface is provided.

A composition for protecting a copper surface containing at least one copper surface protectant selected from a group consisting of compounds represented by formulae (1) to (3) below and salts thereof, and a solvent.

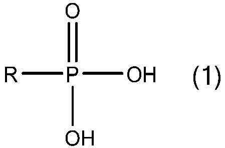

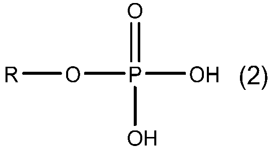

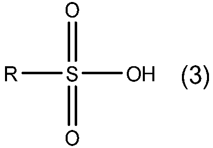

## Description

### Technical Field

The present invention relates to a composition for protecting a copper surface, and methods for producing a semiconductor intermediate and a semiconductor using the same.

### Background Art

In recent years, miniaturization and high functionality of electronic devices have progressed, and miniaturization and high functionality of semiconductors are required.

Three-dimensional (3D) integration technology has attracted attention as a method to address the demand for miniaturization and high functionality of semiconductors. In the 3D integration technology, multiple semiconductor chips or semiconductor wafers are stacked via interconnection, and as a stacked form, Chip to Chip (C2C), Chip to Wafer (C2W), Wafer to Wafer (W2W), and the like are known.

As such 3D integration technology, for example, Patent Literature 1 describes an invention that relates to a semiconductor structure including a semiconductor layer, an adhesive layer disposed above the semiconductor layer, an anode metal layer disposed above the adhesive layer, and a cathode metal layer disposed above the anode metal layer.

Patent Literature 1 describes that in interconnection by Cu-Cu bonding, rapid formation of an oxide on a Cu surface, which inhibits sufficient interconnection, is a serious problem. Patent Literature 1 describes, as a method for inhibiting Cu oxidation, a metal (Mg or the like) having an oxidation potential higher than a Cu oxidation potential is used to form a galvanic pair, and Mg itself is sacrificed, thereby inhibiting or reducing growth of Cu oxide.

### Citation List

### Patent Literature

Patent Literature 1: JP 2020-512703 A

### Summary of Invention

### Technical Problem

In such a situation, a new means for preventing oxidation of the copper surface is required.

### Solution to Problem

The present invention includes, for example, the following aspects.

[1] A composition for protecting a copper surface, containing:
   at least one copper surface protectant selected from a group consisting of compounds represented by formulae (1) to (3) and salts thereof: 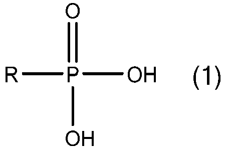 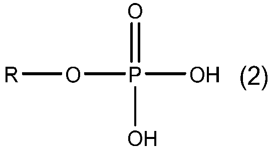 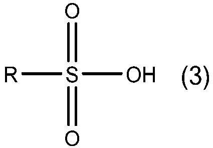 in formulae (1) to (3),
   R is a substituted or unsubstituted alkyl group having 3 to 30 carbon atoms, a substituted or unsubstituted aryl group having 6 to 30 carbon atoms; and
   a solvent.
[2] The composition for protecting a copper surface according to [1], wherein the copper surface protectant contains a compound represented by formula (1) and/or a salt thereof.
[3] The composition for protecting a copper surface according to [1] or [2], wherein R is a substituted or unsubstituted alkyl group having 3 to 30 carbon atoms.
[4] The composition for protecting a copper surface according to any one of [1] to [3], further containing a pH adjusting agent.
[5] The composition for protecting a copper surface according to [4], wherein the pH adjusting agent contains at least one selected from a group consisting of sodium hydroxide and potassium hydroxide.
[6] The composition for protecting a copper surface according to any one of [1] to [5], wherein the pH is 2.5 to 5.5.
[7] The composition for protecting a copper surface according to any one of [1] to [6], which is used for producing a semiconductor.
[8] A method for producing a first semiconductor intermediate including a copper-containing layer and a copper surface protective layer stacked on the copper-containing layer, the method including:
   a step (1) of bringing the composition for protecting a copper surface according to any one of [1] to [7] into contact with a copper-containing layer in a first semiconductor having the copper-containing layer to form a copper surface protective layer.
[9] The method for producing a first semiconductor intermediate according to [8], including a step of washing the copper-containing layer with a washing liquid before the step (1).
[10] The method for producing a first semiconductor intermediate according to [9], wherein the washing liquid contains at least one selected from a group consisting of hydrofluoric acid, sulfuric acid, nitric acid, and ammonia.
[11] A method for producing a semiconductor including a copper-containing bonding layer, the method including:
   a step of removing a copper surface protective layer of a first semiconductor intermediate produced by the method according to any one of [8] to [10] to expose a copper-containing layer; and
   a step of bonding the exposed copper-containing layer to a metal-containing layer in a second semiconductor intermediate including the metal-containing layer to form a copper-containing bonding layer.

### Advantageous Effects of Invention

According to the present invention, a composition for protecting a copper surface capable of preventing oxidation of a copper surface, and the like are provided. As a result, for example, oxidation of a copper surface of a semiconductor can be prevented, and a semiconductor or the like in which interconnection is suitably formed in the 3D integration technology can be produced.

### Description of Embodiments

Hereinafter, embodiments for carrying out the present invention will be described in detail.

### <Composition for protecting copper surface>

A composition for protecting a copper surface contains at least one copper surface protectant selected from a group consisting of compounds represented by formulae (1) to (3) and salts thereof, and a solvent. The composition for protecting a copper surface may further contain a pH adjusting agent, a surfactant, a viscosity adjusting agent, a chelating agent, a reducing agent, an antifoaming agent, or the like. The composition for protecting a copper surface is preferably used for producing a semiconductor.

The composition for protecting a copper surface according to the present invention can prevent oxidation of a copper surface. Specifically, a copper surface protective layer can be formed by bringing the composition for protecting a copper surface into contact with a copper surface (for example, a copper-containing layer included in a semiconductor). Since the copper surface protective layer is a dense layer, penetration of oxygen can be prevented. As a result, contact between the copper surface and oxygen can be prevented, and oxidation of the copper surface can be prevented.

In the 3D integration technology, since a semiconductor is produced by individually producing two semiconductor intermediates having a copper-containing layer to be interconnected and then stacking these, the storage period of the semiconductor intermediates having a copper-containing layer may be prolonged. According to the composition for protecting a surface of the present invention, a copper surface protective layer formed on a copper-containing layer can be stably held for a long period of time, and therefore, a semiconductor intermediate having the copper surface protective layer can be stored for a long period of time.

In one embodiment, the composition for protecting a copper surface has high removability of a copper surface protective layer to be formed, and thus is excellent in usability. Since a bonding force due to a covalent bond is not necessarily required between the copper-copper surface protective layer, for example, the copper surface protective layer can be easily removed by heating, hydrogen ashing, inert gas ion irradiation, or the like. Therefore, the composition for protecting a copper surface is excellent in usability.

### [Copper surface protectant]

The copper surface protectant is selected from the group consisting of compounds represented by formulae (1) to (3) and salts thereof.

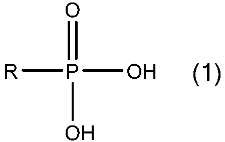

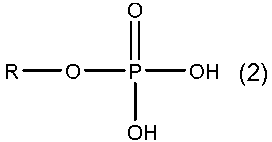

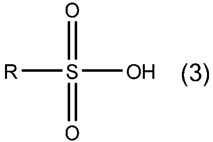

In formulae (1) to (3), R is a substituted or unsubstituted alkyl group having 3 to 30 carbon atoms, a substituted or unsubstituted aryl group having 6 to 30 carbon atoms.

The alkyl group having 3 to 30 carbon atoms is not particularly limited, and examples thereof include a propyl group, an isopropyl group, a butyl group, an isobutyl group, a sec-butyl group, a tert-butyl group, a pentyl group, a heptyl group, a heptyl group, an octyl group, a nonyl group, a decyl group, an undecyl group, a dodecyl group, a tridecyl group, a tetradecyl group, a pentadecyl group, a hexadecyl group, an octadecyl group, and an icosyl group.

The substituent in a case where the alkyl group having 3 to 30 carbon atoms has a substituent is not particularly limited, and examples thereof include an alkoxy group having 1 to 30 carbon atoms such as a methoxy, ethoxy, or propyloxy group; a hydroxy group; a cyano group; a nitro group; and a halogen atom (a fluorine atom, a chlorine atom, a bromine atom, or an iodine atom). The alkyl group may have one substituent or two or more substituents in combination.

Examples of the aryl group having 6 to 30 carbon atoms include a phenyl group, a naphthyl group, and an anthracenyl group.

The substituent in a case where the aryl group having 6 to 30 carbon atoms has a substituent is not particularly limited, and examples thereof include an alkyl group having 1 to 30 carbon atoms such as a methyl group, an ethyl group, a propyl group, an isopropyl group, or a butyl group; an alkoxy group having 1 to 30 carbon atoms such as a methoxy, ethoxy, or propyloxy group; a hydroxy group; a cyano group; a nitro group; and a halogen atom (a fluorine atom, a chlorine atom, a bromine atom, or an iodine atom). The aryl group may have one substituent or two or more substituents in combination.

The "salts thereof' have a structure in which at least one hydroxy group in formulae (1) to (3) is converted into a salt of a hydroxide ion. Specific examples thereof include compounds represented by formulae (1-1) to (3-1) below.

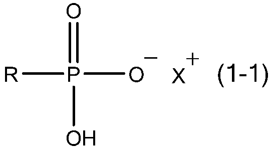

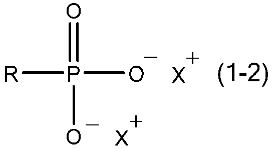

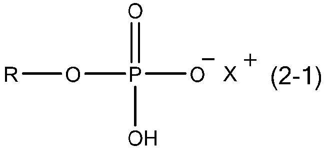

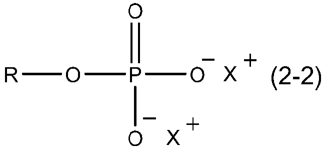

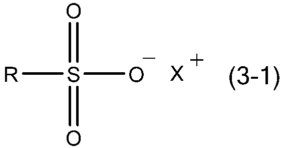

In formulae (1-1) to (3-1), R is similar to that in formulae (1) to (3). Examples of X⁺'s each independently include a monovalent cation. At this time, two X⁺'s between compounds in the compounds of formulae (1-1) to (3-1) and two X⁺'s in the compound in the compounds of formulae (1-2) and (2-2) may be one divalent cation. For example, two compounds of formula (1-1) may have the following structure containing a divalent cation.

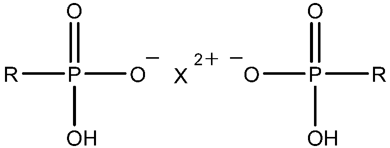

The monovalent cation is not particularly limited, and examples thereof include a sodium cation, a potassium cation, an ammonium cation, and a quaternary ammonium cation (a methylammonium cation, an ethylammonium cation, a dimethylammonium cation, a trimethylammonium cation, or a tetramethylammonium cation). These monovalent cations may be contained alone or two or more types thereof may be contained in combination.

The divalent cation is not particularly limited, and examples thereof include a magnesium cation, a calcium cation, a strontium cation, and a barium cation.

Specific examples of the copper surface protectant include, but are not particularly limited to, compounds represented by formula (1) such as propylphosphonic acid, butylphosphonic acid, pentylphosphonic acid, hexylphosphonic acid, heptylphosphonic acid, octylphosphonic acid, nonylphosphonic acid, decylphosphonic acid, undecylphosphonic acid, dodecylphosphonic acid, phenylphosphonic acid, 4-methylphenylphosphonic acid, and naphthylphosphonic acid; compounds represented by formula (2) such as propyl phosphoric acid, butyl phosphoric acid, pentyl phosphoric acid, hexyl phosphoric acid, heptyl phosphoric acid, octyl phosphoric acid, nonyl phosphoric acid, decyl phosphoric acid, undecyl phosphoric acid, dodecyl phosphoric acid, phenyl phosphoric acid, and 4-nitrophenyl phosphoric acid; compounds represented by formula (3) such as propylbenzenesulfonic acid, butylbenzenesulfonic acid, pentylbenzenesulfonic acid, hexylbenzenesulfonic acid, heptylbenzenesulfonic acid, octylbenzenesulfonic acid, nonylbenzenesulfonic acid, decylbenzenesulfonic acid, undecylbenzenesulfonic acid, dodecylbenzenesulfonic acid, phenylbenzenesulfonic acid, and 4-dodecylbenzenesulfonic acid; and salts thereof. Among these, the copper surface protectant preferably contains at least one of the compounds represented by formula (1) and salts thereof, more preferably contains at least one selected from the group consisting of propylphosphonic acid, butylphosphonic acid, pentylphosphonic acid, hexylphosphonic acid, heptylphosphonic acid, octylphosphonic acid, nonylphosphonic acid, decylphosphonic acid, undecylphosphonic acid, dodecylphosphonic acid, and salts thereof, still more preferably contains at least one selected from the group consisting of heptylphosphonic acid, octylphosphonic acid, nonylphosphonic acid, and salts thereof, and particularly preferably contains octylphosphonic acid and/or a salt thereof. The copper surface protectants described above may be used alone or two or more types thereof may be used in combination.

The content of the copper surface protectant is preferably 0.00001 to 1 mass%, more preferably 0.0001 to 1 mass%, still more preferably 0.001 to 0.5 mass%, and particularly preferably 0.005 to 0.1 mass% with respect to the total mass of the composition for protecting a copper surface. It is preferable that the content of the copper surface protectant is 0.00001 mass% or more because a dense copper surface protective layer can be formed. Meanwhile, it is preferable that the content of the copper surface protectant is 1 mass% or less because a uniform composition is easily prepared.

### [Solvent]

The solvent is not particularly limited, and examples thereof include water and an organic solvent.

The water is not particularly limited, and is preferably water from which metal ions, organic impurities, particles, and the like have been removed by distillation, an ion exchange treatment, a filter treatment, various adsorption treatments, or the like, more preferably pure water, and particularly preferably ultrapure water.

The organic solvent is not particularly limited, and examples thereof include alcohols such as methanol, ethanol, 1-propanol, 2-propanol, 1-butanol, and tert-butanol; polyhydric alcohols such as ethylene glycol, propylene glycol, neopentyl glycol, 1,2-hexanediol, 1,6-hexanediol, 2-ethylhexane-1,3-diol, and glycerin; glycol ethers such as diethylene glycol monomethyl ether, diethylene glycol monoethyl ether, diethylene glycol monobutyl ether, propylene glycol monomethyl ether, propylene glycol monoethyl ether, dipropylene glycol monomethyl ether, tripropylene glycol monomethyl ether, dipropylene glycol dimethyl ether, dipropylene glycol monoethyl ether, propylene glycol n-propyl ether, dipropylene glycol n-propyl ether, tripropylene glycol n-propyl ether, propylene glycol n-butyl ether, dipropylene glycol n-butyl ether, tripropylene glycol n-butyl ether, and propylene glycol phenyl ether.

Among the above, the solvent is more preferably water. The solvents described above may be used alone or two or more types thereof may be used in combination.

The addition rate of the solvent, particularly water is preferably 50 mass% or more, more preferably 80 mass% or more, still more preferably 90 mass% or more, and particularly preferably 95 mass% or more with respect to the total mass of the composition for protecting a copper surface.

### [pH adjusting agent]

The pH adjusting agent has a function of adjusting the pH of the composition for protecting a copper surface.

Examples of the pH adjusting agent include an acidic compound and a basic compound.

The acidic compound is not particularly limited, and examples thereof include inorganic strong acid compounds such as hydrogen chloride, hydrogen bromide, hydrogen iodide, sulfuric acid and nitric acid; organic strong acid compounds such as methanesulfonic acid and benzenesulfonic acid; inorganic weak acid compounds such as phosphoric acid; and organic weak acid compounds such as acetic acid and citric acid.

The basic compound is not particularly limited, and examples thereof include inorganic strong base compounds such as sodium hydroxide, potassium hydroxide, calcium hydroxide, and barium hydroxide; organic strong base compounds such as tetramethylammonium hydroxide (TMAH) and tetraethylammonium hydroxide (TEAR); inorganic weak base compounds such as sodium carbonate and ammonia; and organic weak base compounds such as diazabicycloundecene (DBU) and diazabicyclononene (DBU).

Among these, the pH adjusting agent preferably contains at least one selected from the group consisting of an inorganic strong acid compound, an inorganic strong base compound, and an inorganic weak base compound, more preferably contains at least one selected from the group consisting of sulfuric acid, nitric acid, sodium hydroxide, potassium hydroxide, calcium hydroxide, tetramethylammonium hydroxide (TMAH), tetraethylammonium hydroxide (TEAR), and ammonia, still more preferably contains at least one selected from the group consisting of sodium hydroxide, potassium hydroxide, calcium hydroxide, tetramethylammonium hydroxide (TMAH), tetraethylammonium hydroxide (TEAR), and ammonia, and particularly preferably contains at least one selected from the group consisting of sodium hydroxide, potassium hydroxide, and calcium hydroxide. The pH adjusting agents described above may be used alone or two or more types thereof may be used in combination.

The content of the pH adjusting agent is not particularly limited, and is preferable such an amount that the pH of the composition for protecting a copper surface achieves a desired pH.

### [Physical properties of composition for protecting copper surface]

The pH of the composition for protecting a copper surface is preferably 0.1 to 13, more preferably 1 to 12.5, still more preferably 2 to 12, and still more preferably 2.5 to 5.5. A suitable copper surface protective layer can be formed on a copper surface by adjusting the pH of the composition for protecting a copper surface. The reason why such an effect is obtained is not necessarily clear, but for example, a change in surface potential (ζ potential) of copper due to pH can be mentioned. Specifically, when the pH of the composition for protecting a copper surface is acidic (pH is less than 7.0), the copper surface tends to have a large amount of positive charge, and when the pH is basic (pH is more than 7.0), the copper surface tends to have a large amount of negative charge. It is considered that the copper surface protectant contained in the composition for protecting a copper surface can suitably interact with the copper surface by such a change in surface potential (ζ potential) of copper.

### <Method for producing semiconductor intermediate>

According to an embodiment of the present invention, a method for producing a semiconductor intermediate is provided. At this time, the semiconductor intermediate (first semiconductor intermediate) includes a copper-containing layer and a copper surface protective layer stacked on the copper-containing layer. Then, the method for producing a semiconductor intermediate includes a step (1) of bringing the composition for protecting a copper surface into contact with a copper-containing layer in the first semiconductor having the copper-containing layer to form a copper surface protective layer. Further, the semiconductor intermediate may include a step of washing the copper-containing layer with a washing liquid (washing step) before the step (1). Hereinafter, the washing step and the step (1) will be described in this order. In the present description, the "copper-containing layer" means a layer in which at least copper, which is a metal, is present on the layer surface, and the copper-containing layer is preferably a layer made of copper.

### [Washing step]

The washing step is performed before the step (1). The washing step is a step of washing a copper-containing layer in the first semiconductor having the copper-containing layer with a washing liquid.

### (First semiconductor)

The first semiconductor includes a copper-containing layer. The first semiconductor is not particularly limited, and examples thereof include a semiconductor chip and a semiconductor wafer.

### (Washing liquid)

The washing liquid has a function of washing the surface of the copper-containing layer, for example, a function of removing copper oxide formed on the exposed surface of the copper-containing layer.

The washing liquid contains a washing agent and a solvent.

The washing agent is not particularly limited, and contains at least one selected from the group consisting of an acid and an alkali.

The acid is not particularly limited, and examples thereof include inorganic acids such as hydrofluoric acid, hydrogen chloride, hydrogen bromide, hydrogen iodide, sulfuric acid, nitric acid, and phosphoric acid; and organic acids such as acetic acid, methanesulfonic acid, trifluoromethanesulfonic acid, benzenesulfonic acid, p-toluenesulfonic acid, and 10-camphorsulfonic acid.

The alkali is not particularly limited, and examples thereof include ammonia and ammonium salts.

The ammonium salt is not particularly limited, and examples thereof include ammonium fluoride (NH₄F); ammonium hydrogen fluoride (NH₄F·HF); tetraalkylammonium hydroxides such as tetraethylammonium hydroxide (TEAR), tetramethylammonium hydroxide (TMAH), ethyltrimethylammonium hydroxide, diethyldimethylammonium hydroxide, triethylmethylammonium hydroxide, tetrapropylammonium hydroxide, and tetrabutylammonium hydroxide; aryl group-containing ammonium hydroxides such as benzyltrimethylammonium hydroxide and benzyltriethylammonium hydroxide; and hydroxy group-containing ammonium hydroxides such as trimethyl(2-hydroxyethyl)ammonium hydroxide, triethyl(2-hydroxyethyl)ammonium hydroxide, tripropyl(2-hydroxyethyl)ammonium hydroxide, and trimethyl(1-hydroxypropyl)ammonium hydroxide.

Among these, the washing agent preferably contains at least one selected from the group consisting of acids and ammonia, more preferably contains at least one selected from the group consisting of hydrofluoric acid, hydrogen chloride, hydrogen bromide, hydrogen iodide, sulfuric acid, nitric acid, and ammonia, still more preferably contains at least one selected from the group consisting of hydrofluoric acid, sulfuric acid, nitric acid, and ammonia, particularly preferably contains at least one selected from the group consisting of sulfuric acid, nitric acid, and ammonia, and most preferably contains sulfuric acid. The washing agents may be used alone or two or more types thereof may be used in combination.

The content of the washing agent is preferably 0.001 to 50 mass%, more preferably 0.01 to 10 mass%, still more preferably 0.03 to 3 mass%, and particularly preferably 0.05 to 2 mass% with respect to the total mass of the washing liquid.

The solvent is not particularly limited, and examples thereof include solvents similar to those used for the composition for protecting a copper surface. Among these, the solvent is preferably water. The solvents described above may be used alone or two or more types thereof may be used in combination.

The addition rate of the solvent, particularly water is preferably 50 mass% or more, more preferably 80 mass% or more, still more preferably 90 mass% or more, and particularly preferably 95 mass% or more with respect to the total mass of the washing liquid.

The washing liquid may further contain a pH adjusting agent. The pH adjusting agent is not particularly limited, and examples thereof include pH adjusting agents similar to those used for the composition for protecting a copper surface. These pH adjusting agents may be used alone or two or more types thereof may be used in combination.

The pH of the washing liquid is not particularly limited, and is preferably 0.1 to 13, more preferably 0.5 to 10, still more preferably 0.5 to 5, and particularly preferably 0.4 to 2.5.

### (Washing)

The washing method is not particularly limited, and a known technique can be appropriately adopted. Specifically, the first semiconductor may be immersed in the washing liquid, or the washing liquid may be sprayed or dropped (a single wafer spinning process or the like) onto the surface of the copper-containing layer of the first semiconductor. In this case, the immersion may be repeated two or more times, the spraying may be repeated two or more times, the dropping may be repeated two or more times, or the immersion, the spraying, and the dropping may be combined.

The washing temperature is not particularly limited, and is preferably 0 to 90°C, more preferably 5 to 70°C, and still more preferably 10 to 50°C.

The washing time is not particularly limited, and is preferably 10 seconds to 3 hours, more preferably 10 seconds to 1 hour, still more preferably 15 seconds to 45 minutes, and particularly preferably 30 seconds to 20 minutes.

### [Step (1)]

The step (1) is a step of bringing the composition for protecting a copper surface into contact with a copper-containing layer in a first semiconductor having the copper-containing layer to form a copper surface protective layer.

### (First semiconductor)

As the first semiconductor, those described above are used. At this time, in the first semiconductor, copper oxide that can be included in the copper-containing layer is preferably removed through the above washing step.

### (Composition for protecting copper surface)

As the composition for protecting a copper surface, those described above are used.

### (Contact)

The contact method is not particularly limited, and a known technique can be appropriately adopted. Specifically, the first semiconductor may be immersed in the composition for protecting a copper surface, or the composition for protecting a copper surface may be sprayed or dropped (a single wafer spinning process or the like) onto the surface of the copper-containing layer of the first semiconductor. In this case, the immersion may be repeated two or more times, the spraying may be repeated two or more times, the dropping may be repeated two or more times, or the immersion, the spraying, and the dropping may be combined.

The contact temperature is not particularly limited, and is preferably 0 to 90°C, more preferably 5 to 70°C, and still more preferably 10 to 65°C.

The contact time is not particularly limited, and is preferably 10 seconds to 3 hours, more preferably 10 seconds to 1 hour, still more preferably 1 to 45 minutes, and particularly preferably 3 to 20 minutes.

After the contact, the excessive composition for protecting a copper surface or the like is appropriately washed with water, isopropyl alcohol, or the like to remove the solvent contained in the composition for protecting a copper surface attached to the surface of the copper-containing layer, whereby a copper surface protective layer can be formed.

### [Copper surface protective layer]

The copper surface protective layer contains a copper surface protectant. The copper surface protective layer is a dense layer, and therefore oxygen is difficult to penetrate. As a result, contact of oxygen with the copper-containing layer can be prevented, and oxidation of the surface of the copper-containing layer can be prevented.

The thickness of the copper surface protective layer is not particularly limited, and is preferably 0.1 to 50 nm, more preferably 0.2 to 10 nm, still more preferably 0.3 to 2 nm, and particularly preferably 0.4 to 1 nm. In the present description, the thickness of the "copper surface protective layer" means the maximum thickness of the copper surface protective layer in the direction perpendicular to the contact surface between the copper-containing layer and the copper surface protective layer.

### [First semiconductor intermediate]

The first semiconductor intermediate includes a copper-containing layer and a copper surface protective layer stacked on the copper-containing layer. The copper surface protective layer may cover some or all of other layers such as an insulating layer and a silicon substrate layer in addition to the copper-containing layer depending on the structure of the first semiconductor.

Since the copper surface protective layer is formed on the copper-containing layer, the first semiconductor intermediate can prevent oxidation of the surface of the copper-containing layer. Therefore, the first semiconductor intermediate can be stored for a long period of time.

### <Method for producing semiconductor>

According to an embodiment of the present invention, a method for producing a semiconductor is provided. At this time, the semiconductor includes a copper-containing bonding layer. The method for producing a semiconductor includes a step of removing a copper surface protective layer of a first semiconductor intermediate produced by the method to expose a copper-containing layer (exposing step) and a step of bonding the exposed copper-containing layer to a metal-containing layer in a second semiconductor intermediate including the metal-containing layer to form a copper-containing bonding layer (bonding step). In the present description, the "metal-containing layer" means a layer in which at least a metal is present on the layer surface, and the metal-containing layer is preferably a layer made of a metal. At this time, the "metal" is one that can be bonded to copper, and is preferably copper or tin, and is more preferably copper.

### [Exposing step]

The exposing step is a step of removing the copper surface protective layer of the first semiconductor intermediate to expose the copper-containing layer.

### (First semiconductor intermediate)

As the first semiconductor intermediate, those described above are used.

### (Removal)

The method for removing the copper surface protective layer of the first semiconductor intermediate is not particularly limited, and is preferably heating, hydrogen ashing, and inert gas ion irradiation, and more preferably heating. In addition, heating may be performed in an inert gas atmosphere. Examples of the inert gas include nitrogen and argon.

The heating temperature is not particularly limited, and is preferably 100 to 300°C, and more preferably 150 to 250°C.

The heating time is not particularly limited, and is preferably 0.1 seconds to 3 hours, more preferably 1 second to 1 hour, still more preferably 10 seconds to 15 minutes, and particularly preferably 1 minute to 15 minutes.

The copper-containing layer can be exposed by removing the copper surface protective layer of the first semiconductor. That is, the first semiconductor having a copper-containing layer is obtained.

### [Bonding step]

The bonding step is a step of bonding the exposed copper-containing layer to the metal-containing layer in the second semiconductor intermediate including the metal-containing layer to form a copper-containing bonding layer.

### (Exposed copper-containing layer)

Copper on the surface of the exposed copper-containing layer is hardly oxidized because the exposed copper-containing layer is covered with the copper surface protective layer and hardly comes in contact with oxygen until the exposing step is performed.

### (Second semiconductor intermediate containing metal-containing layer)

The second semiconductor intermediate includes a metal-containing layer. The second semiconductor intermediate is not particularly limited, and examples thereof include a semiconductor chip and a semiconductor wafer. When the metal-containing layer is a copper-containing layer, the second semiconductor intermediate may be one produced in the same manner as the first semiconductor intermediate. In this case, it is used in the bonding step through the exposing step.

### (Bonding)

By bonding, the copper-containing layer and the metal-containing layer are interconnected, and a three-dimensional (3D) integrated semiconductor can be obtained.

The bonding method is not particularly limited, and is preferably thermocompression bonding.

The bonding temperature is not particularly limited, and is preferably 80 to 500°C, more preferably 90 to 300°C, still more preferably 100 to 250°C, and particularly preferably 120 to 200°C.

The bonding time is not particularly limited, and is preferably 0.01 to 600 seconds, and more preferably 0.1 to 60 seconds.

### Examples

Hereinafter, the present invention will be described in more detail with reference to Examples, but the present invention is not limited to these Examples.

### [Example 1]

Butylphosphonic acid as a copper surface protectant and water as a solvent were mixed to produce a composition for protecting a copper surface. At this time, the content of butylphosphonic acid was 0.01 mass% with respect to the total mass of the composition for protecting a copper surface.

The pH of the composition for protecting a copper surface was measured and found to be 3.2. The pH was measured at 23°C using a tabletop pH meter (F-71) (manufactured by HORIBA, Ltd.) and a pH electrode (9615S-10D) (manufactured by HORIBA, Ltd.).

### [Example 2]

A composition for protecting a copper surface was produced in the same manner as in Example 1 except that hexylphosphonic acid was used as the copper surface protectant. The pH of the composition for protecting a copper surface was measured in the same manner as in Example 1, and found to be 3.3.

### [Example 3]

A composition for protecting a copper surface was produced in the same manner as in Example 1 except that octylphosphonic acid was used as the copper surface protectant. The pH of the composition for protecting a copper surface was measured in the same manner as in Example 1, and found to be 3.4.

### [Example 4]

A composition for protecting a copper surface was produced in the same manner as in Example 1 except that dodecylphosphoric acid was used as the copper surface protectant so that the content was 0.001 mass%. The pH of the composition for protecting a copper surface was measured in the same manner as in Example 1, and found to be 4.5.

### [Example 5]

A composition for protecting a copper surface was produced in the same manner as in Example 1 except that phenylphosphonic acid was used as the copper surface protectant. The pH of the composition for protecting a copper surface was measured in the same manner as in Example 1, and found to be 3.2.

### [Example 6]

A composition for protecting a copper surface was produced in the same manner as in Example 1 except that 4-dodecylbenzenesulfonic acid was used as the copper surface protectant so that the content was 0.05 mass%. The pH of the composition for protecting a copper surface was measured in the same manner as in Example 1, and found to be 2.9.

### [Example 7]

A composition for protecting a copper surface was produced in the same manner as in Example 3 except that sulfuric acid was further added as a pH adjusting agent so that the content was 1 mass%. The pH of the composition for protecting a copper surface was measured in the same manner as in Example 1, and found to be 1.2.

### [Example 8]

A composition for protecting a copper surface was produced in the same manner as in Example 3 except that sulfuric acid was further added as a pH adjusting agent so that the content was 0.05 mass%. The pH of the composition for protecting a copper surface was measured in the same manner as in Example 1, and found to be 2.1.

### [Example 9]

A composition for protecting a copper surface was produced in the same manner as in Example 3 except that ammonia was further added as a pH adjusting agent so that the content was 0.0006 mass%. The pH of the composition for protecting a copper surface was measured in the same manner as in Example 1, and found to be 4.0.

### [Example 10]

A composition for protecting a copper surface was produced in the same manner as in Example 3 except that ammonia was further added as a pH adjusting agent so that the content was 0.0007 mass%. The pH of the composition for protecting a copper surface was measured in the same manner as in Example 1, and found to be 5.0.

### [Example 11]

A composition for protecting a copper surface was produced in the same manner as in Example 3 except that ammonia was further added as a pH adjusting agent so that the content was 0.0012 mass%. The pH of the composition for protecting a copper surface was measured in the same manner as in Example 1, and found to be 6.0.

### [Example 12]

A composition for protecting a copper surface was produced in the same manner as in Example 3 except that ammonia was further added as a pH adjusting agent so that the content was 0.0014 mass%. The pH of the composition for protecting a copper surface was measured in the same manner as in Example 1, and found to be 7.0.

### [Example 13]

A composition for protecting a copper surface was produced in the same manner as in Example 3 except that ammonia was further added as a pH adjusting agent so that the content was 0.0016 mass%. The pH of the composition for protecting a copper surface was measured in the same manner as in Example 1, and found to be 8.0.

### [Example 14]

A composition for protecting a copper surface was produced in the same manner as in Example 3 except that ammonia was further added as a pH adjusting agent so that the content was 0.0031 mass%. The pH of the composition for protecting a copper surface was measured in the same manner as in Example 1, and found to be 9.0.

### [Example 15]

A composition for protecting a copper surface was produced in the same manner as in Example 3 except that ammonia was further added as a pH adjusting agent so that the content was 0.013 mass%. The pH of the composition for protecting a copper surface was measured in the same manner as in Example 1, and found to be 10.0.

### [Example 16]

A composition for protecting a copper surface was produced in the same manner as in Example 3 except that tetramethylammonium hydroxide (TMAH) was further added as a pH adjusting agent so that the content was 0.018 mass%. The pH of the composition for protecting a copper surface was measured in the same manner as in Example 1, and found to be 11.0.

### [Example 17]

A composition for protecting a copper surface was produced in the same manner as in Example 3 except that tetramethylammonium hydroxide (TMAH) was further added as a pH adjusting agent so that the content was 0.075 mass%. The pH of the composition for protecting a copper surface was measured in the same manner as in Example 1, and found to be 12.0.

### [Example 18]

A composition for protecting a copper surface was produced in the same manner as in Example 3 except that sodium hydroxide (NaOH) was further added as a pH adjusting agent so that the content was 0.0026 mass%. The pH of the composition for protecting a copper surface was measured in the same manner as in Example 1, and found to be 5.0.

### [Example 19]

A composition for protecting a copper surface was produced in the same manner as in Example 3 except that potassium hydroxide (KOH) was further added as a pH adjusting agent so that the content was 0.0029 mass%. The pH of the composition for protecting a copper surface was measured in the same manner as in Example 1, and found to be 5.0.

### [Comparative Example 1]

A composition was produced in the same manner as in Example 1 except that, in place of the copper surface protectant, benzotriazole was used so that the content was 0.05 mass%. The pH of the composition was measured in the same manner as in Example 1, and found to be 5.2.

### [Comparative Example 2]

A composition was produced in the same manner as in Example 1 except that, in place of the copper surface protectant, dodecylpyridinium chloride was used so that the content was 0.05 mass%. The pH of the composition was measured in the same manner as in Example 1, and found to be 4.7.

### [Comparative Example 3]

A composition was produced in the same manner as in Example 1 except that, in place of the copper surface protectant, 1-hydroxyethane-1,1-diphosphonic acid was used so that the content was 0.5 mass%. The pH of the composition was measured in the same manner as in Example 1, and found to be 1.7.

### [Comparative Example 4]

A composition was produced in the same manner as in Example 1 except that, in place of the copper surface protectant, poly(ammonium 4-styrenesulfonate) (weight average molecular weight Mw = 200,000) was used so that the content was 0.05 mass%. The pH of the composition was measured in the same manner as in Example 1, and found to be 4.8.

The compositions for protecting a copper surface and the like produced in Examples 1 to 19 and Comparative Examples 1 to 4 are shown in Table 1 below.

**[Table 1]**

| | Copper surface protectant | | pH adjusting agent | | pH |
|---|---|---|---|---|---|
| | Type | Content (mass%) | Type | Content (mass%) | |
| Example 1 | Butylphosphonic acid | 0.01 | - | 0 | 3.2 |
| Example 2 | Hexylphosphonic acid | 0.01 | - | 0 | 3.3 |
| Example 3 | Octylphosphonic acid | 0.01 | - | 0 | 3.4 |
| Example 4 | Dodecylphosphoric acid | 0.001 | - | 0 | 4.5 |
| Example 5 | Phenylphosphonic acid | 0.01 | - | 0 | 3.2 |
| Example 6 | 4-Dodecylbenzenesulfonic acid | 0.05 | - | 0 | 2.9 |
| Example 7 | Octylphosphonic acid | 0.01 | Sulfuric acid | 1 | 1.2 |
| Example 8 | Octylphosphonic acid | 0.01 | Sulfuric acid | 0.05 | 2.1 |
| Example 9 | Octylphosphonic acid | 0.01 | Ammonia | 0.0006 | 4.0 |
| Example 10 | Octylphosphonic acid | 0.01 | Ammonia | 0.0007 | 5.0 |
| Example 11 | Octylphosphonic acid | 0.01 | Ammonia | 0.0012 | 6.0 |
| Example 12 | Octylphosphonic acid | 0.01 | Ammonia | 0.0014 | 7.0 |
| Example 13 | Octylphosphonic acid | 0.01 | Ammonia | 0.0016 | 8.0 |
| Example 14 | Octylphosphonic acid | 0.01 | Ammonia | 0.0031 | 9.0 |
| Example 15 | Octylphosphonic acid | 0.01 | Ammonia | 0.013 | 10.0 |
| Example 16 | Octylphosphonic acid | 0.01 | TMAH | 0.018 | 11.0 |
| Example 17 | Octylphosphonic acid | 0.01 | TMAH | 0.075 | 12.0 |
| Example 18 | Octylphosphonic acid | 0.01 | NaOH | 0.0026 | 5.0 |
| Example 19 | Octylphosphonic acid | 0.01 | KOH | 0.0029 | 5.0 |
| Comparative Example 1 | Benzotriazole | 0.05 | - | 0 | 5.2 |
| Comparative Example 2 | Dodecylpyridinium chloride | 0.05 | - | 0 | 4.7 |
| Comparative Example 3 | 1-Hydroxyethane-1,1-diphosphonic acid | 0.5 | - | 0 | 1.7 |
| Comparative Example 4 | Poly(ammonium 4-styrenesulfonate) | 0.05 | - | 0 | 4.8 |

Structural formulae of copper surface protectants and the like used in Examples and Comparative Examples are shown below.

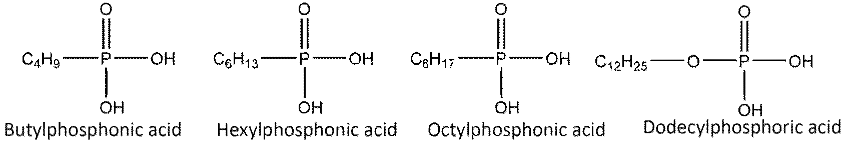

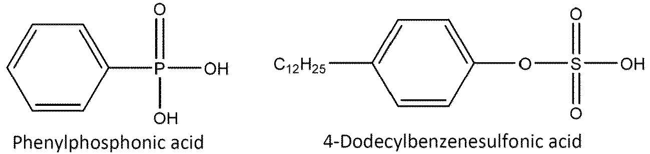

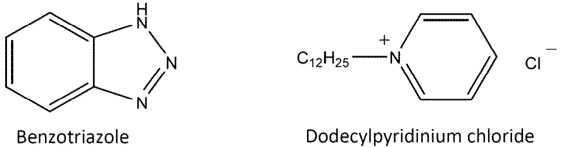

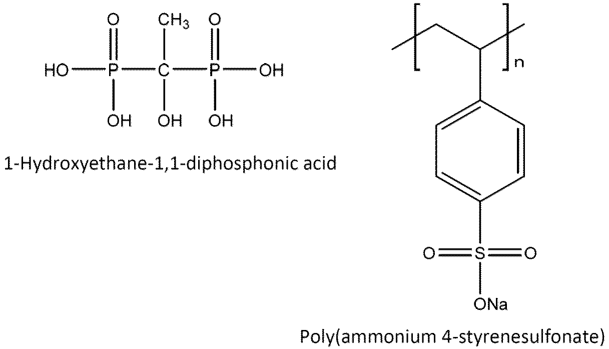

### [Evaluation]

The compositions for protecting a copper surface and the like produced in Examples 1 to 19 and Comparative Examples 1 to 4 were subjected to various evaluations.

### (Copper oxidation rate)

### (1) Preparation of plated Cu sample

A plated Cu sample was prepared by sequentially depositing SiO₂ (thickness: 1,000 Å), TaN (thickness: 50 Å), Ta (thickness: 100 Å), seed Cu (thickness: 600 Å), and plated Cu (thickness: 6,000 Å) on a silicon substrate.

### (2) Pretreatment

A plated Cu sample of 1 cm × 1 cm (immersion treatment area: 1 cm²) was immersed in 10 mL of 1% hydrofluoric acid (DHF) at 23°C for 1 minute to remove copper oxide (CuO) on the surface of the plated Cu sample. Subsequently, the surface was rinsed with water at 23°C for 10 seconds, and then blown with nitrogen to remove water from the surface.

### (3) Formation of copper surface protective layer

The plated Cu sample after copper oxide was removed was immersed in a composition for protecting a copper surface or the like at 20°C for 10 minutes. Subsequently, the surface was rinsed with water at 23°C for 10 seconds, and then blown with nitrogen to remove water from the surface, and thus a copper surface protective layer was formed on the plated Cu sample.

### (4) Evaluation of copper oxidation rate

The plated Cu sample on which the copper surface protective layer was formed was stored in the air at 20°C for 24 hours or 120 hours.

The copper oxidation rate of the plated Cu sample having the copper surface protective layer after storage was measured. Specifically, the plated Cu sample having the copper surface protective layer after storage was analyzed by X-ray photoelectron spectroscopy (XPS; PHI Quantera II manufactured by ULVAC-PHI, Inc.) to obtain a narrow scan spectrum of Cu2p. The obtained narrow scan spectrum of Cu2p was analyzed by curve fitting, and the peak area of Cu²⁺ alone and the sum of the peak areas of Cu⁺ and Cu were calculated. The copper oxidation rate (a value obtained by dividing the peak area of Cu²⁺ by the sum of the peak areas of Cu⁺ and Cu) was determined using the obtained peak areas. It means that the higher the copper oxidation rate is, that is, the more Cu²⁺ exists than Cu⁺ and Cu, the more the surface of the plated Cu layer of the Cu sample was oxidized during the storage period of the plated Cu sample. The obtained results are shown in Table 2 below. Table 2 also shows the results of Reference Example in which "(3) Formation of copper surface protective layer" was not performed (the composition for protecting a copper surface or the like was not used).

### (Removability of copper surface protective layer)

### (1) Preparation and pretreatment of Cu sample

A plated Cu sample subjected to a pretreatment was prepared in the same manner as in the evaluation of the copper oxidation rate described above.

### (2) Formation of copper surface protective layer

The plated Cu sample after copper oxide was removed was immersed in a composition for protecting a copper surface or the like at 20°C for 10 minutes. Subsequently, the surface was rinsed with water at 23°C for 10 seconds, and then blown with nitrogen to remove water from the surface, and thus a plated Cu sample on which a copper surface protective layer was formed was obtained. The contact angle of water on the surface of the plated Cu sample on which the copper surface protective layer was formed was measured and found to be 60° or more. Since the copper surface protective layer is an organic layer, the contact angle of water tends to be larger than that on the copper surface having a high surface free energy.

### (3) Evaluation of removability of copper surface protective layer

The Cu sample on which the copper surface protective layer was formed was allowed to stand for 5 minutes on a hot plate heated to 200°C to remove the copper surface protective layer.

The contact angle of water on the surface of the Cu sample before and after the sample was left to stand on the hot plate was measured and evaluated according to the following criteria. When the copper surface protective layer is removed by heating, the copper surface having a high surface free energy is exposed, and the contact angle tends to decrease. The obtained results are shown in Table 2 below.

∘: The contact angle of water is less than 25°.
×: The contact angle of water is 25° or more.

**[Table 2]**

| | Copper oxidation rate (%) (after 1 day) | Copper oxidation rate (%) (after 5 days) | Removability |
|---|---|---|---|
| Example 1 | 5 | 12 | ○ |
| Example 2 | 2 | 10 | ○ |
| Example 3 | 5 | 7 | ○ |
| Example 4 | 4 | N.D. | ○ |
| Example 5 | 3 | 14 | ○ |
| Example 6 | 9 | N.D. | ○ |
| Example 7 | N.D. | 11 | ○ |
| Example 8 | N.D. | 10 | ○ |
| Example 9 | N.D. | 4 | ○ |
| Example 10 | N.D. | 4 | ○ |
| Example 11 | N.D. | 11 | ○ |
| Example 12 | N.D. | 11 | ○ |
| Example 13 | N.D. | 14 | ○ |
| Example 14 | N.D. | 7 | ○ |
| Example 15 | N.D. | 8 | ○ |
| Example 16 | N.D. | 7 | ○ |
| Example 17 | N.D. | 5 | ○ |
| Example 18 | N.D. | 1 | ○ |
| Example 19 | N.D. | 1 | ○ |
| Comparative Example 1 | 36 | N.D. | ○ |
| Comparative Example 2 | 21 | N.D. | N.D. |
| Comparative Example 3 | 37 | N.D. | N.D. |
| Comparative Example 4 | 29 | N.D. | N.D. |
| Reference Example | 28 | N.D. | - |

| | | | |
|---|---|---|---|
| *N.D.: No Data | | | |

From the results in Table 2, it is found that the compositions for protecting a copper surface of Examples 1 to 19 could suitably prevent oxidation of the copper surface by protecting the copper surface.

### [Effect of pretreatment agent]

The effect of a pretreatment agent on the copper surface before the copper surface protective layer is formed by the composition for protecting a copper surface was evaluated.

### (1) 1% Hydrofluoric acid (DHF)

The copper oxidation rate and removability were evaluated in the same manner as described above using the composition for protecting a copper surface of Example 3. This example is an example using 1% hydrofluoric acid (DHF) as the pretreatment agent.

### (2) 1% Sulfuric acid

The copper oxidation rate and removability were evaluated in the same manner as in the above (1) except that 1% sulfuric acid was used as the pretreatment agent.

### (3) 0.1% Ammonia

The copper oxidation rate and removability were evaluated in the same manner as in the above (1) except that 0.1% ammonia was used as the pretreatment agent.

The results obtained in the above (1) to (3) are shown in Table 3 below.

**[Table 3]**

| | Composition for protecting copper surface | Pretreatment agent | Copper oxidation rate (%) (after 1 day) | Copper oxidation rate (%) (after 5 days) | Removability |
|---|---|---|---|---|---|
| (1) | Example 3 | 1% Hydrofluoric acid | 5 | 7 | ○ |
| (2) | Example 3 | 1% Sulfuric acid | N.D. | 1 | ○ |
| (3) | Example 3 | 0.1% Ammonia | N.D. | 3 | ○ |

| | | | | | |
|---|---|---|---|---|---|
| *N.D.: No Data | | | | | |

From the results in Table 3, it is found that oxidation of the copper surface could be suitably prevented by protecting the copper surface even when any pretreatment agent was used.

## Claims

1. A composition for protecting a copper surface, comprising: at least one copper surface protectant selected from a group consisting of compounds represented by formulae (1) to (3) and salts thereof: 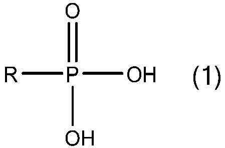 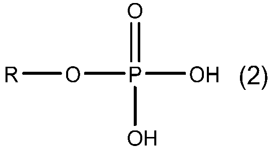 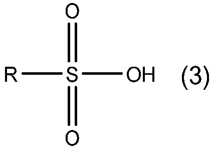 in formulae (1) to (3),
R is a substituted or unsubstituted alkyl group having 3 to 30 carbon atoms, a substituted or unsubstituted aryl group having 6 to 30 carbon atoms; and
a solvent.

2. The composition for protecting a copper surface according to claim 1, wherein the copper surface protectant contains a compound represented by formula (1) and/or a salt thereof.

3. The composition for protecting a copper surface according to claim 1 or 2, wherein R is a substituted or unsubstituted alkyl group having 3 to 30 carbon atoms.

4. The composition for protecting a copper surface according to any one of claims 1 to 3, further comprising a pH adjusting agent.

5. The composition for protecting a copper surface according to claim 4, wherein the pH adjusting agent contains at least one selected from a group consisting of sodium hydroxide and potassium hydroxide.

6. The composition for protecting a copper surface according to any one of claims 1 to 5, wherein the pH is 2.5 to 5.5.

7. The composition for protecting a copper surface according to any one of claims 1 to 6, which is used for producing a semiconductor.

8. A method for producing a first semiconductor intermediate including a copper-containing layer and a copper surface protective layer stacked on the copper-containing layer, the method comprising:
a step (1) of bringing the composition for protecting a copper surface according to any one of claims 1 to 7 into contact with a copper-containing layer in a first semiconductor having the copper-containing layer to form a copper surface protective layer.

9. The method for producing a first semiconductor intermediate according to claim 8, comprising a step of washing the copper-containing layer with a washing liquid before the step (1).

10. The method for producing a first semiconductor intermediate according to claim 9, wherein the washing liquid contains at least one selected from a group consisting of hydrofluoric acid, sulfuric acid, nitric acid, and ammonia.

11. A method for producing a semiconductor including a copper-containing bonding layer, the method comprising:
a step of removing a copper surface protective layer of a first semiconductor intermediate produced by the method according to any one of claims 8 to 10 to expose a copper-containing layer; and
a step of bonding the exposed copper-containing layer to a metal-containing layer in a second semiconductor intermediate including the metal-containing layer to form a copper-containing bonding layer.
